# EUROPÄISCHE PATENTSCHRIFT

(11) **EP 1 864 314 B1**
(45) Veröffentlichungstag und Bekanntmachung des Hinweises auf die Patenterteilung: **16.05.2012**
(21) Anmeldenummer: 06705365.2
(22) Anmeldetag: 01.03.2006
(51) Int. Cl.: C23C 14/32, C23C 14/02, C23C 14/06, C23C 14/08, F01D 5/28, C23C 28/04

(54) **VERFAHREN ZUM BETRIEB EINER GEPULSTEN ARCVERDAMPFERQUELLE SOWIE EINE VAKUUMPROZESSANLAGE MIT GEPULSTER ARCVERDAMPFUNGSQUELLE**
METHOD FOR OPERATING A PULSED ARC EVAPORATION SOURCE AND VACUUM PROCESS SYSTEM COMPRISING SAID PULSED ARC EVAPORATION SOURCE
PROCEDE DE FONCTIONNEMENT D'UNE SOURCE D'EVAPORATION PAR ARC PULSEE ET INSTALLATION DE TRAITEMENT SOUS VIDE DOTEE D'UNE SOURCE D'EVAPORATION PAR ARC PULSEE

(30) Priorität: 24.03.2005 CH 5182005; 03.08.2005 CH 12892005
(43) Veröffentlichungstag der Anmeldung: 12.12.2007
(73) Patentinhaber: Oerlikon Trading AG, Trübbach, 9477 Trübbach (CH)
(72) Erfinder: RAMM, Jürgen, CH-7304 Maienfeld (CH); WIDRIG, Beno, CH-7310 Bad Ragaz (CH); LENDI, Daniel, CH-9472 Grabs (CH); DERFLINGER, Volker, A-6800 Feldkirch (AT); REITER, Andreas, A-6800 Feldkirch (AT)
(74) Vertreter: Wegmann, Urs
(86) Internationale Anmeldenummer: PCT/CH2006/000125
(87) Internationale Veröffentlichungsnummer: WO 2006/099760

(56) Entgegenhaltungen:
- EP-A- 0 666 335
- WO-A-02/070776
- DE-A1- 19 902 146
- JP-A- 1 042 574
- US-A- 4 645 895

## Beschreibung

Die Erfindung bezieht sich auf eine Vakuumprozessanlage zur Oberflächenbearbeitung von Werkstücken mit einer Arcverdampferquelle gemäss dem Oberbegriff von Anspruch 1 sowie auf ein Verfahren zum Betrieb einer Arcverdampferquelle gemäss dem Oberbegriff von Anspruch 14.

Der Betrieb von Arcverdampferquellen, auch als Funkenkathoden bekannt, durch Speisen mit elektrischen Pulsen ist aus dem Stand der Technik schon seit längerer Zeit bekannt. Mit Arcverdampferquellen können wirtschaftlich hohe Verdampfungsraten und somit hohe Abscheideraten bei der Beschichtung erzielt werden. Ausserdem ist der Aufbau einer derartigen Quelle technisch relativ einfach zu realisieren, solange keine höheren Anforderungen an den Pulsbetrieb gestellt werden und sich das pulsen mehr oder weniger nur auf das Zünden einer DC-Entladung beschränkt. Diese Quellen arbeiten bei Strömen typischerweise im Bereich von etwa 100A und mehr und bei Spannungen von einigen Volt bis einigen 10 Volt, welche mit relativ kostengünstigen Gleichstromversorgungen realisiert werden können. Ein wesentlicher Nachteil bei diesen Quellen besteht darin, dass es im Bereich des Kathodenfleckes zu sehr rasch verlaufenden Aufschmelzungen an der Targetoberfläche kommt, wodurch Tropfen gebildet werden, so genannte Droplets, welche als Spritzer weggeschleudert werden und dann am Werkstück kondensieren und die Schichteigenschaften somit unerwünscht beeinflussen. Beispielweise wird dadurch die Schichtstruktur inhomogen und die Oberflächenrauhigkeit schlecht. Bei hohen Anforderungen an die Schichtqualität können derartig erzeugte Schichten oft kommerziell nicht eingesetzt werden. Es wurde deshalb bereits versucht diese Probleme zu reduzieren indem die Arcverdampferquelle im reinen Pulsbetrieb der Stromversorgung betrieben wird. Mit dem Pulsbetrieb konnte zwar teilweise die Ionisierung bereits erhöht werden, aber die Spritzerbildung wurde je nach Einstellung der Betriebsparameter sogar zusätzlich negativ beeinflusst.

Die Verwendung von reaktiven Gasen zur Abscheidung von Verbindungen ab einem metallischen Target in einem reaktiven Plasma war bis anhin nur sehr eingeschränkt möglich, da sich das Problem der Spritzerbildung bei derartigen Prozessen zusätzlich verstärkt, insbesondere dann, wenn nicht-leitende, also dielektrische Schichten erzeugt werden sollen, wie bspw. Oxyde unter Verwendung von Sauerstoff als Reaktivgas. Die dem Prozess in diesem Fall inhärente Wiederbelegung der Target Oberflächen des Arcverdampfers und der Gegenelektroden, wie den Anoden und auch anderen Teilen der Vakuumprozessanläge mit einer nicht-leitenden Schicht führt zu völlig instabilen Verhältnissen und gar zum Auslöschen des Lichtbogens. In diesem Fall müsste dieser dann immer wieder neu gezündet werden oder die Prozessführung wird dadurch gänzlich verunmöglicht.

In der EP 0 666 335 B1 wird für die Abscheidung von rein metallischen Materialien mit einem Arcverdampfer vorgeschlagen, dem Gleichstrom einen pulsierenden Strom zu überlagern, um hierdurch den DC - Grundstrom erniedrigen zu können zur Reduzieren der Spritzerbildung. Hierbei sind Pulsströme bis zu 5000A notwendig, welche mit Kondensatorentladungen erzeugt werden sollen bei relativ tiefen Pulsfrequenzen im Bereich von 100Hz bis 50kHz. Dieses Vorgehen wird vorgeschlagen zur Verhinderung der Dropletbildung beim nicht-reaktiven Verdampfen von rein metallischen Targets mit einer Arcverdampferquelle. Eine Lösung zur Abscheidung von nicht-leitenden, dielektrischen Schichten wird in dieser Schrift nicht angegeben.

Eine ähnliche Anordnung wie in der zuvor beschriebenen EP 0 666 335 B1 wird in der Japanischen Offenlegungsschrift JP 01 042574 offenbart. Dort soll das Problem der Oberflächenrauheit einer Beschichtung verbessert werden. Dazu wird vorgeschlagen eine Arcverdampferquelle mit DC zu speisen der eine Hochfrequenzspannung (RF - 100Khz bis 100Mhz) überlagert werden soll. Die Vakuumkammer ist als Anode geschaltet. In der Figur ist diese kombinierte Speisung als Power Source 10 (Kästchen) dargestellt. Zusätzlich ist aus der Figur eine bekannte Anordnung ersichtlich zur Anlegung einer DC - Bias - Spannung 11 an die Substrathalterung. Hierbei wird in bekannter Weise der negative Pol an den Substrathalter gelegt und der positive Pol an Anlagenmasse.

Die US 4,645 895 beschreibt eine Anordnung zur Behandlung der Oberfläche eines Werkstückes mit einer voneinander kurz beabstandeten Anode und einer Kathode welche mit einer gepulsten Gleichspannung gespiesen werden zur Erzeugung einer Entladung zwischen dieser Anode und der an Masse liegenden Kathode. Es handelt sich um monopolare DC - Pulse und die Anordnung wird bei relativ tiefer Frequenz intermitierend betrieben, so dass immer wieder gezündet werden muss.

Bei der reaktiven Beschichtung mittels Arcverdampferquellen besteht eine mangelnde Reaktivität und Prozesstabilität, besonders bei der Herstellung isolierender Schichten. Im Gegensatz zu anderen PVD Prozessen (z.B. Sputtern), lassen sich isolierende Schichten mittels Arcverdampfung nur mit elektrisch leitenden Targets herstellen. Ein Arbeiten mit Hochfrequenz, wie es beim Sputtern der Fall ist, scheitert bisher an der fehlenden Technik, Hochstromversorgungen mit hohen Frequenzen betreiben zu können. Das Arbeiten mit gepulsten Stromversorgungen scheint eine Option zu sein. Allerdings muss dann der Funken, wie erwähnt, immer wieder gezündet werden oder die Pulsfrequenz muss so gross gewählt werden, dass der Funke nicht verlischt. Das scheint bei Anwendungen für spezielle Materialien, wie Graphit einigermassen zu funktionieren.

Bei oxidierten Targetoberflächen ist ein neuerliches Zünden über mechanischen Kontakt und mittels DC - Versorgungen nicht möglich. Andere Arten von schnellen Zündvorgängen sind technisch aufwendig und in ihrer Zündfrequenz begrenzt. Das eigentliche Problem bei der reaktiven Arcverdampfung sind die Belegungen mit isolierenden Schichten auf Target und auf der Anode bzw. der Beschichtungskammer. Diese Belegungen erhöhen die Brennspannung der Funkenentladung, führen zu vermehrten Spritzern und Überschlägen, ei-nem instabilen Prozess, der in einem Unterbruch der Funkenentladung endet. Einher geht eine Belegung des Targets mit Inselwachstum, das die leitende Oberfläche verringert. Ein stark verdünntes Reaktivgas (z.B. Argon/Sauerstoff-Gemisch) kann das Zuwachsen am Target verzögern, aber das grundsätzliche Problem der Prozessinstabilität nicht lösen. Der Vorschlag gemäss der US 5,103,766, die Kathode und die Anode wechselweise zu betreiben mit jeweilig neuerlichem Zünden, trägt wohl zur Prozessstabilität bei, führt aber zu vermehrten Spritzern.

Der Ausweg über eine gepulste Stromversorgung wie es etwa beim reaktiven Sputtern möglich ist, kann bei einer klassischen Funkenverdampfung nicht gegangen werden. Das liegt daran, dass eine Glimmentladung "länger lebt" als ein Funke, wenn man die Stromzufuhr unterbricht.

Um dem Problem der Belegung des Targets mit einer isolierenden Schicht aus dem Weg zu gehen, wird bei reaktiven Prozessen zur Herstellung isolierender Schichten entweder der Reaktivgaseinlass vom Target örtlich getrennt (dann ist die Reaktivität des Prozesses nur gewährleistet, falls auch die Temperatur am Substrat eine Oxidation/Reaktion ermöglicht) oder es wird eine Trennung zwischen Spritzern und ionisiertem Anteil vorgenommen (sog. filtered arc) und das Reaktivgas nach der Filterung dem ionisiertem Dampf beigegeben. Die vorherigen Patentanmeldung mit Anmeldenummer CH 00518/05 zeigt im wesentlichen für dieses Problem einen Lösungsansatz auf und die in der vorliegenden Patentanmeldung vorgestellte Erfindung stellt eine Weiterentwicklung dar, welche Priorität auf diese Anmeldung nimmt und diese somit integrierender Bestandteil dieser Anmeldung ist.

Im Gegensatz zum Sputtern ist die Beschichtung mittels kathodischem Funken im Wesentlichen ein Verdampfungsprozess. Man vermutet, dass im Übergang zwischen heissen Kathodenfleck und dessen Rand Teile mitgerissen werden, die nicht von atomarer Grösse sind. Diese Konglomerate treffen als solche auf dem Substrat auf und resultieren in rauen Schichten, die in den Spritzern nicht voll durchreagiert werden können. Die Vermeidung bzw. Zerteilung dieser Spritzer ist bisher nicht gelungen, schon gar nicht für reaktive Beschichtungsprozesse. Bei diesem bildet sich auf der Funkenkathode, in beispielsweise Sauerstoffatmosphäre, zusätzlich noch eine dünne Oxidschicht, die zu vermehrter Spritzerbildung neigt. In der vorerwähnten Patentanmeldung CH00518/05 wurde eine erste Lösung angegeben, die besonders gut für vollständig reagierte Targetoberflächen geeignet ist und eine deutlich verminderte Spritzerbildung aufweist. Trotzdem ist eine weitere Reduktion der Spritzer und ihrer Grösse wünschenswert.

Weiter besteht der Wunsch der zusätzlichen Reduktions- bzw. Skalierbarkeitsmöglichkeit der thermischen Belastung der Substrate und die Möqlichkeit Niedertemperaturprozesse bei der kathodischen Funkenbeschichtung zu führen.

In der WO-03018862 wird der Pulsbetrieb von Plasmaquellen als ein möglicher Weg beschrieben, die thermische Belastung am Substrat zu reduzieren. Allerdings gelten dort die Begründungen wohl für den Bereich der Sputterprozesse. Es wird kein Bezug zur Funkenverdampfung hergestellt.

In Bezug zum Stand der Technik werden zusammenfassend folgende Nachteile aufgeführt:
1. Die Reaktivität bei Beschichtungen mittels kathodischem Arcverdampfen ist unzureichend.
2. Es besteht keine grundsätzliche Lösung der Spritzerproblematik: Konglomerate (Spritzer) werden nicht voll durchreagiert -> Rauhigkeit der Schichtoberfläche, Gleichförmigkeit der Schichtstruktur und Stöchiometrie.
3. Keine stabilen Prozesse möglich zur Abscheidung isolierender Schichten.
4. Die Nachionisierungsmöglichkeit von Spritzern ist ungenügend.
5. Unzureichende Möglichkeiten Niedertemperaturprozesse zu realisieren.
6. Eine weitere Reduktion der thermischen Belastung der Substrate ist ungenügend.

Die Aufgabe der vorliegenden Erfindung liegt darin die vorerwähnten Nachteile des Standes der Technik zu beseitigen. Insbesondere besteht die Aufgabe darin, Schichten wirtschaftlich abzuscheiden mit mindestens einer Arcverdampferquelle, derart, dass die Reaktivität beim Prozess durch bessere Ionisierung des verdampften Materials und des, beim Prozess beteiligten, Reaktivgases erhöht wird. Bei diesem reaktiven Prozess soll die Grösse und Häufigkeit der Spritzer wesentlich reduziert werden, insbesondere bei reaktiven Prozessen zur Herstellung isolierender Schichten. Weiter soll eine bessere Prozesskontrolle ermöglicht werden, wie die Kontrolle der Verdampfungsraten, Erhöhung der Schichtqualität, Einstellbarkeit der Schichteigenschaften, Verbesserung der Homogenität der Reaktion, sowie die Verminderung der Oberflächenrauhigkeit der abgeschiedenen Schicht. Diese Verbesserungen sind insbesondere auch von Bedeutung bei der Herstellung von gradierten Schichten und/ oder Legierungen.

Die Prozessstabilität bei reaktiven Prozessen zur Herstellung isolierender Schichten soll generell erhöht werden. Ausserdem soll ein Niedertemperaturprozess realisiert werden können auch bei hoher Wirtschaftlichkeit des Verfahrens. Im Weiteren soll der Aufwand für die Vorrichtung und insbesondere für die Leistungsversorgung für den gepulsten Betrieb gering gehalten werden können. Die vorerwähnten Aufgaben können sowohl einzeln wie auch in ihrer Kombination abhängig vom jeweiligen, geforderten Einsatzbereich auftreten.

Die Aufgabe wird erfindungsgemäss durch eine Vakuumprozessanlage nach Anspruch 1 gelöst und durch Vorgehen nach einem Verfahren nach Anspruch 14. Die abhängigen Ansprüche definieren weitere vorteilhafte Ausführungsformen.

Die Aufgabe wird erfindungsgemäss dadurch gelöst, dass eine Vakuumprozessanlage zur Oberflächenbearbeitung von Werkstücken mit mindestens einer Arcverdampferquelle vorgesehen ist, welche mit einer DC Stromversorgung verbunden ist und eine erste Elektrode darstellt, wobei zusätzlich eine, von der Arcverdampferquelle getrennt angeordnete, zweite Elektrode vorgesehen ist und dass die beiden Elektroden mit einer Pulsstromversorgung verbunden sind. Zwischen den beiden Elektroden wird somit eine zusätzliche Entladungsstrecke betrieben mit nur einer einzelnen Pulsstromversorgung, welche eine besonders hohe Ionisation der beteiligten Materialien ermöglicht bei sehr guter Kontrollierbarkeit des Prozesses.

Die zweite Elektrode kann hierbei eine weitere Arcverdampferquelle sein, eine Sputterquelle, wie vorzugsweise eine Magnetronquelle, eine Werkstückhalterung bzw. das Werkstück selbst, wodurch die zweite Elektrode in diesem Fall als Bias Elektrode betrieben wird oder die zweite Elektrode kann auch als Verdampfungstiegel ausgebildet sein, welcher die Anode eines Niedervoltbogen Verdampfers bildet.

Eine besonders bevorzugte Ausbildung besteht darin, dass beide Elektroden die Kathoden je einer Arcverdampferquelle sind und dass diese Arcverdampferquellen beide direkt mit je einer DC-Stromversorgung verbunden sind zur Aufrechterhaltung des Funkenstroms derart, dass die Arcs bzw. die Bogenentladungen der beiden Quellen im bipolaren Betrieb mit der Pulsstromversorgung nicht gelöscht werden. In dieser Konfiguration wird somit nur eine Pulsstromversorgung benötigt, da diese unmittelbar zwischen die beiden Kathoden der Arcverdampfer geschaltet ist. Neben dem hohen Ionisierungsgrad und der guten Kontrollierbarkeit des Prozesses stellt sich auch ein hoher Wirkungsgrad der Anordnung ein. Zwischen diesen beiden Elektroden und der dadurch zusätzlich erzeugten Puls Entladungsstrecke bildet sich gegenüber dieser Entladungsstrecke elektrisch ein bipolarer Puls aus mit negativen und positiven Anteilen wodurch die ganze Periodendauer dieser eingespeisten Wechselspannung für den Prozess genutzt werden kann. Tatsächlich entstehen keine ungenutzten Pulspausen und sowohl der negative wie auch der positive Puls leisten ohne Unterbruch insgesamt den Beitrag an den Prozess. Das trägt zur Spritzerreduktion bei, stabilisiert reaktive Beschichtungsprozesse, erhöht die Reaktivität und die Abscheiderate ohne zusätzliche teure Pulsstromversorgungen einsetzten zu müssen. Diese Anordnung, mit zwei Arcverdampferquellen, ist besonders geeignet zur Abscheidung von Schichten ab einem metallischen Target unter Verwendung von reaktivem Gas. Plasmaprozesse betrieben mit Edelgasen, wie mit Argon, sind bekanntlich recht stabil. Sobald Reaktivgase dazu kommen, um verschiedene metallische und halb-metallische Verbindungen abscheiden zu können, wird die Prozessführung schwierig, da die Prozessparameter sich dann verschieben und folglich Instabilitäten auftreten, die, die Prozessführung gar verunmöglichen können. Diese Problematik tritt besonders in Erscheinung, wenn nicht-leitende Schichten erzeugt werden sollen, wie insbesondere oxydische Schichten unter Verwendung von Sauerstoff als Reaktivgas. Die vorerwähnte Anordnung mit zwei Arcverdampferquellen löst dieses Problem auf einfach Art und Weise. Mit dieser Anordnung wird es sogar möglich gänzlich auf stützende Edelgase, wie Argon zu verzichten und es kann mit reinem Reaktivgas gearbeitet werden, sogar überraschenderweise mit reinem Sauerstoff. Durch den damit hohen erreichbaren Ionisierungsgrad, sowohl des abgedampften Materials wie auch des Reaktivgases, wie mit Sauerstoff, werden nicht-leitende Schichten erzeugt mit hoher Qualität, die nahe an die Qualität des Bulk Materials hinreichen. Der Prozess läuft hierbei sehr stabil und überraschenderweise wird hierbei auch noch die Spritzerbildung drastisch reduziert oder beinahe gänzlich vermieden. Die vorerwähnten Vorteile könne aber auch erzielt werden durch Verwendung von anderen Quellen als zweite Elektrode, wie für eine Sputterelektode, eine Biaselektrode, einer Hilfselektrode oder einen Niedervoltbogenverdampfertiegel, obwohl die erwähnten vorteilhaften Auswirkungen nicht in dem selben Mass erreicht werden wie bei der Ausbildung der Anordnung mit zwei Arcverdampfern.

Die Erfindung wird im Nachfolgenden beispielsweise und schematisch mit Figuren näher erläutert. Es zeigen:
- Fig. 1: schematisch eine Darstellung einer Arcverdampfer Beschichtungsanlage, wie sie dem Stand der Technik entspricht;
- Fig. 2: eine erfindungsgemässe Anordnung mit zwei DC gespeisten Arcverdampferquellen bei Betrieb mit überlagertem Hochstrompuls;
- Fig. 3: Anordnung mit zwei DC gespeisten Arcverdampferquellen und dazwischen geschalteter Hochstrompulsversorgung gemäss Erfindung mit massefreiem Betrieb;
- Fig. 4: eine Anordnung mit DC gespeister Arcverdampferquelle und einer zweiten Elektrode als Substrathalter mit dazwischen geschalteter Hochstrompulsversorgung;
- Fig. 5: Anordnung mit einer DC betriebenen Arcverdampferquelle und der zweiten Elektrode als DC betriebene Magnetronsputterquelle mit dazwischen geschalteten Hochstrompulsversorgung;
- Fig. 6: Anordnung mit einer DC gespeisten Arcverdampferquelle und mit einer zweiten Elektrode als Verdampfungstiegel einer Niedervoltbogenverdampfungsanordnung und dazwischen geschalteter Hochstrompulsversorgung;
- Fig. 7: die Spannungspulsform der Hochstrompulsversorgung.

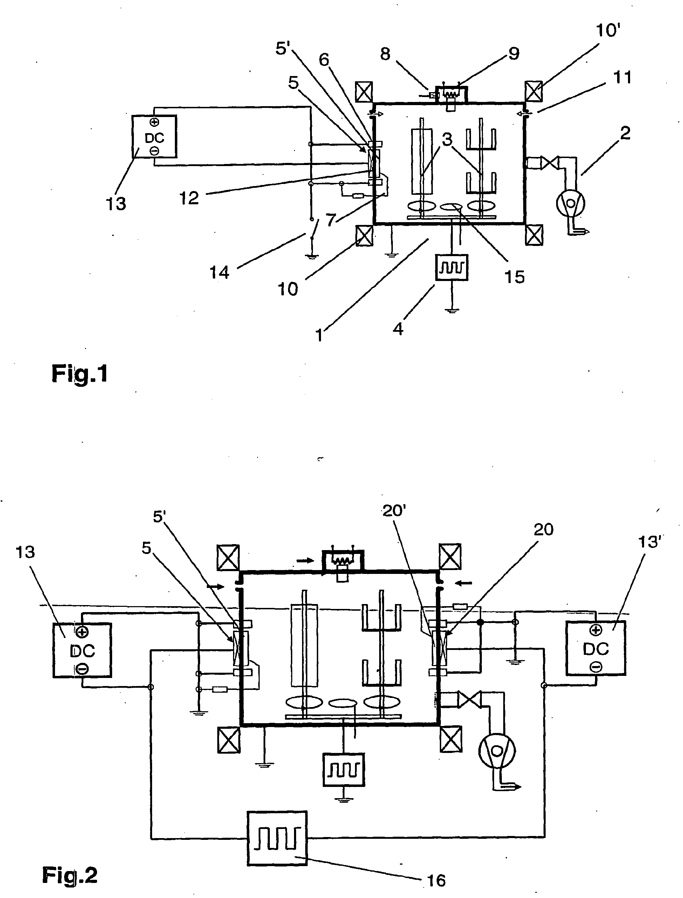

In Fig. 1 ist eine Vakuumprozessanlage dargestellt, welche eine aus dem Stand der Technik bekannte Anordnung zeigt zum Betreiben einer Arcverdampferquelle (5) mit einer DC-Stromversorgung (13). Die Anlage (1) ist mit einem Pumpsystem (2) ausgerüstet zur Erstellung des notwendigen Vakuums in der Kammer der Vakuumprozessanlage (1). Das Pumpsystem (2) ermöglicht den Betrieb der Beschichtungsanlage bei Drucken < 10⁻¹ mbar und stellt auch den Betrieb sicher mit den typischen Reaktivgasen, wie O₂, N₂, SiH₄, Kohlenwasserstoffe, etc.. Die Reaktivgase werden über einen Gaseinlass (11) in die Kammer (1) eingelassen und dort entsprechend verteilt. Es ist zusätzlich möglich durch weitere Gaseinlasse zusätzliche Reaktivgase einzulassen oder aber auch Edelgase, wie Argon, wenn dies notwendig erscheint, um die Gase einzeln und/oder in Mischungen zu benutzen. Die in der Anlage angeordnete Werkstückhalterung (3) dient der Aufnahme und der elektrischen Kontaktierung der hier nicht mehr dargestellten Werkstücke, welche üblicherweise aus metallischen oder keramischen Materialien gefertigt sind und die mit Hartstoff- oder Verschleissschutzschichten in derartigen Prozessen beschichtet werden. Eine Bias - Stromversorgung (4) ist elektrisch mit der Werkstückhalterung (3) verbunden zur Anlegung einer Substratspannung bzw. einer Biasspannung an die Werkstücke. Die Bias - Stromversorgung (4) kann eine DC, eine AC oder eine bi- bzw. eine unipolare Puls - Substratstromversorgung sein. Über einen Prozessgaseinlass (11) kann ein Edel- bzw. ein Reaktivgas eingelassen werden, um Prozessdruck und Gaszusammensetzung in der Behandlungskammer vorzugeben und zu steuern.

Bestandteil der Arcverdampferquelle (5) sind ein Target 5' mit dahinter liegender Kühlplatte und vorzugsweise mit Magnetsystem, ein Zündfinger (7), der im Peripheriebereich der Targetoberfläche angeordnet ist sowie eine das Target umschliessende Anode (6). Mit einem Schalter (14) ist es möglich zwischen einem floatenden Betrieb der Anode (6) des positiven Pols der Stromversorgung (13) und einem Betrieb mit definiertem Null- bzw. Massepotenzial zu wählen. Mit dem Zündfinger (7) wird bspw. beim Zünden des Lichtbogens der Arcverdampferquelle (5) ein kurzzeitiger Kontakt mit der Kathode hergestellt und dieser dann weggezogen, wodurch ein Funken gezündet wird. Der Zündfinger (7) ist hierzu bspw. über einen Strombegrenzungswiderstand mit Anodenpotenzial verbunden.

Die Vakuumprozessanlage (1) kann zusätzlich fakultativ, wenn die Prozessführung es notwendig macht mit einer zusätzlichen Plasmaquelle (9) ausgerüstet werden. In diesem Fall ist die Plasmaquelle (9) als Quelle zur Erzeugung eines Niedervoltbogens mit Heisskathode ausgebildet. Die Heisskathode ist bspw. als Filament ausgebildet, welches in einer kleinen Ionisationskammer angeordnet ist, in welches mit einem Gaseinlass (8) ein Arbeitsgas, wie bspw. Argon eingelassen wird, zur Erzeugung einer Niedervoltbogenentladung, die sich in die Hauptkammer der Vakuumprozessanlage (1) erstreckt. Eine Hilfsanode (15) für die Ausbildung der Niedervoltbogenentladung ist in der Kammer der Vakuumprozessanlage (1) entsprechend positioniert angeordnet und wird auf bekannte Art und Weise mit einer DC-Stromversorgung zwischen Kathode und der Plasmaquelle (9) und der Anode (15) betrieben. Bei Bedarf können zusätzliche Spulen (10, 10') vorgesehen werden, wie bspw. helmholzartige Anordnungen, die um die Vakuumprozessanlage (1) gelegt werden, zur magnetischen Bündelung bzw. Führung des Niedervoltbogenplasmas.

Erfindungsgemäss wird nun neben einer ersten Arcverdampferquelle (5) mit der Targetelektrode (5') eine zweite Arcverdampferquelle (20) mit der zweiten Targetelektrode (20') vorgesehen, wie dies in Fig. 2 dargestellt ist. Beide Arcverdampferquellen (5, 20), werden mit je einer DC-Stromversorgung (13) und (13') betrieben, derart, dass die DC-Stromversorgungen mit einem Grundstrom die Aufrechterhaltung der Bogenentladung gewährleisten. Die DC-Stromversorgungen (13, 13') entsprechen dem heutigen Stand der Technik und können kostengünstig realisiert werden. Die beiden Elektroden (5`, 20'), welche die Kathoden der beiden Arcverdampferquellen (5, 20) bilden sind entsprechend der vorliegenden Erfindung mit einer einzelnen Pulsstromversorgung (16) verbunden, welche in der Lage ist, an die beiden Elektroden (5',20') hohe Pulsströme mit definierter Form und Flankensteilheit der Pulse abzugeben. In der dargestellten Anordnung nach Fig. 2 sind die Anoden (6) der beiden Arcverdampferquellen (5, 20) auf das elektrische Potenzial der Masse der Prozessanlage (1) bezogen.

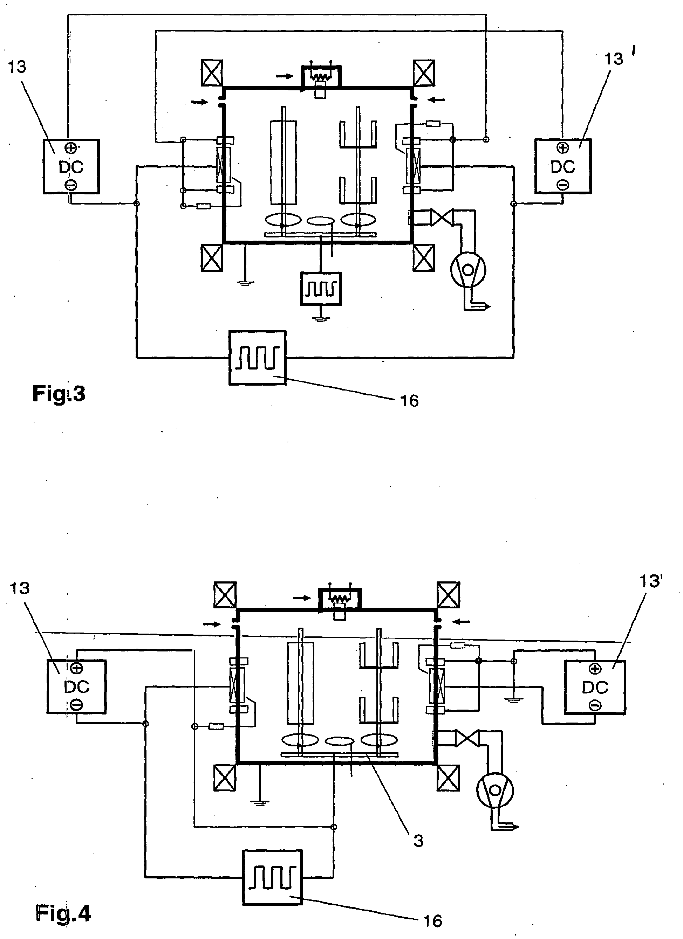

Wie in Fig. 3 dargestellt ist, ist es aber auch möglich die Funkenentladungen massefrei zu betreiben. In diesem Fall wird die erste DC-Stromversorgung (13) mit deren minus Pol mit der Kathode (5') der ersten Arcverdampferquelle (5) verbunden und deren positiver Pol mit der gegenüberliegenden Anode der zweiten Arcverdampferquelle (20) verbunden. Die zweite Arcverdampferquelle (20) wird analog betrieben und die zweite Stromversorgung (13') ist mit dem positiven Pol der Anode der ersten Arcverdampferquelle (5) verbunden. Dieser gegenüberliegende Betrieb der Anoden der Arcverdampferquellen führt zu einer besseren Ionisierung der Materialien im Prozess. Der massefreie Betrieb, bzw. der floatende oder schwebende Betrieb der Arcverdampferquelle (5, 20) kann aber auch ohne Verwendung der gegenüberliegenden Anodeneinspeisung erfolgen. Ausserdem ist es möglich, einen Schalter (14) vorzusehen, um wahlweise zwischen massefreien und massegebundenen Betrieb umschalten zu können. Wie vorher sind die beiden Elektroden (5', 20'), welche die Kathoden der beiden Arcverdampferquellen (5, 20) bilden, entsprechend der vorliegenden Erfindung mit einer einzelnen Pulsstromversorgung (16) verbunden

Die Versorgung für diesen "Dual Pulsed Mode" muss verschiedene Impedanzbereiche überstreichen können und trotz allem noch "hart" in der Spannung sein. Das bedeutet, dass die Versorgung hohe Ströme liefern muss, aber dabei trotzdem weitgehend spannungsstabil betrieben werden kann. Ein Beispiel einer solchen Versorgung wird parallel mit gleichem Datum zu dieser Patentanmeldung mit der Nr...... angemeldet.

Der erste und bevorzugte Anwendungsbereich dieser Erfindung ist derjenige der kathodischen Funkenverdampfung mit zwei gepulsten Arcverdampferquellen (5, 20) wie er in Figur 2 dargestellt ist. Für diese Anwendungen liegen die Impedanzen im Intervall von etwa 0.01 Ω bis 1 Ω. Es muss hier noch angemerkt werden, dass gewöhnlich die Impedanzen der Quellen, zwischen denen "dual gepulst" wird, unterschiedlich sind. Das kann daran liegen, dass diese aus verschiedenen Materialien bzw. Legierungen bestehen, dass das Magnetfeld der Quellen unterschiedlich ist oder dass der Materialabtrag der Quellen in einem unterschiedlichen Stadium ist. Der "Dual Pulsed Mode" erlaubt nun einen Abgleich über das Einstellen der Pulsbreite derart, dass beide Quellen den gleichen Strom ziehen. Als Folge führt das zu unterschiedlichen Spannungen an den Quellen. Natürlich kann die Versorgung auch asymmetrisch bezüglich des Stromes belastet werden, wenn es für die Prozessführung wünschenswert erscheint, was beispielsweise der Fall ist für gradierte Schichten unterschiedlicher Materialien. Die Spannungsstabilität einer Versorgung lässt sich immer schwieriger realisieren, je kleiner die Impedanz des jeweiligen Plasmas ist. Deshalb sind kurze Pulslängen oft von Vorteil. Die Umschaltbarkeit bzw. die gesteuerte Nachführbarkeit einer Versorgung auf verschiedene Ausgangsimpedanzen ist deshalb von besonderem Vorteil, falls man den vollen Bereich ihrer Leistung ausnutzen möchte, also beispielsweise vom Bereich 500 V/100 A auf 50 V/1000 A oder wie es in der parallelen Anmeldung Nr......... realisiert wird.

Die Vorteile einer solchen dual gepulsten Kathodenanordnung und insbesondere bestehend aus zwei Arcverdampferquellen sind zusammengefasst folgende:
1. Erhöhte Elektronenemission bei steilen Pulsen resultiert in höherem Strom (auch Substratstrom) und erhöhten Ionisierung des verdampften Materials und des Reaktivgases;
2. Die erhöhte Elektronendichte trägt auch zu einer schnelleren Entladung der Substratoberfläche bei, bei der Herstellung isolierender Schichten d.h. relativ kleine Umladezeiten am Substrat (oder auch nur Pulspausen der Biasspannung) sind ausreichend, um die sich bildenden isolierende Schichten zu entladen;
3. Der bipolare Betrieb zwischen den beiden kathodischen Arcverdampferquellen erlaubt einen quasi 100%iges Puls-Pausenverhältnis (duty cycle), während das Pulsen einer Quelle allein notwendigerweise immer eine Pause benötigt und deshalb die Effizienz nicht so hoch ist;
4. Der dual gepulste Betrieb zweier kathodischen Funkenquellen, die einander gegenüberliegen, taucht den Substratbereich in dichtes Plasma ein und erhöht die Reaktivität in diesem Bereich, auch vom Reaktivgas. Das zeigt sich auch an der Erhöhung des Substratstromes;
5. Bei reaktiven Prozessen in Sauerstoffatmosphäre können im gepulsten Betrieb noch höhere Elektronenemissionswerte erreicht werden und es scheint, dass sich ein Aufschmelzen des Funkenbereiches wie es bei der klassischen Verdampfung von metallischen Targets der Fall ist, weitgehend vermeiden lässt.

Eine weitere bevorzugte Variante der vorliegenden Erfindung besteht darin, dass als zweite Elektrode, neben der ersten Elektrode der Arcverdampferquelle (5), die Werkstückhalterung (3) mit den darauf befindlichen Werkstücken benutzt wird, wie dies in Fig. 4 dargestellt ist. In diesem Fall wird die einzelne Pulsstromversorgung (16) zwischen die erste Elektrode (5') der Arcverdampferquelle (5) und die zweite Elektrode ausgebildet als Werkstückhalterung (3) angeschlossen. Um stabilere Entladebedingungen erzielen zu können, kann zusätzlich die DC-Stromversorgung (13) der Arcverdampferquelle (5) gleichzeitig auch mit der zweiten Elektrode, der Werkstückhalterung, verbunden werden. Mit diesem Biasbetrieb können ebenfalls die Ionisierungsverhältnisse, insbesondere im Bereich der Werkstückoberfläche gezielt beeinflusst werden. In dieser Variante sind die Impedanzen wesentlich voneinander verschieden. Auch hier kann ein Stromabgleich über die Spannungspulsbreite erfolgen. Da die Elektronenemission von Substrathalterung und Substraten sich stark von der Elektronenemission des kathodischen Arcverdampfers unterscheidet, weist die resultierende gepulste Spannung keinen Nulldurchgang auf (Substrat ist immer anodisch). Wichtig bei dieser Variante ist wieder die Anwendung bei der Herstellung isolierender Schichten und zusätzlich die Möglichkeit, das Substrat mit hohen Elektronenströmen zu beaufschlagen. Dieser Betrieb ist vor allem dann interessant, wenn es darum geht Reaktivgase in der Nähe der Substratoberfläche zu dissoziieren und gleichzeitig hohe Substrattemperaturen zu realisieren.

Die Vorteile sind zusammengefasst:
1. Hohe Reaktivität in Substratnähe;
2. Effiziente Zerlegung des Reaktivgases;
3. Entladung der Substrate bei der Abscheidung von isolierenden Schichten;
4. Realisierung hoher Substrattemperaturen möglich.

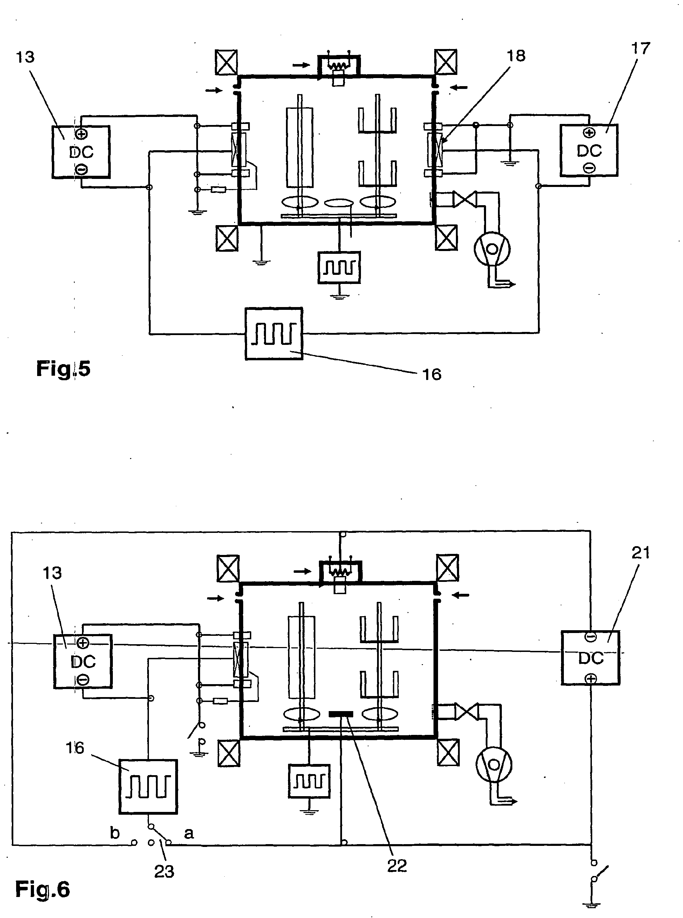

Eine weitere Variante der Erfindung ist in Fig. 5 dargestellt, wobei hier die zweite Elektrode als Zerstäubungstarget (Sputtertarget) an einer Zerstäubungsquelle (18) ausgebildet ist. Bevorzugterweise ist diese Zerstäubungsquelle (18) als Magnetron Zerstäubungsquelle ausgebildet und wird in üblicherweise mit einer DC-Stromversorgung (17) gespiesen. Mit dieser Anordnung können die Vorteil der Zerstäubungstechnik kombiniert werden mit den Vorteilen der Arcverdampfertechnik und dies auch bei reaktiven Prozessen, insbesondere bei der Abscheidung von dielektrischen Schichten oder Gradienten- und Legierungsschichten.

Auch in diesem Fall sind die Impedanzen sehr unterschiedlich. Sie liegen zwischen den bereits oben erwähnten Arcverdampferquellen und denen des Sputterns mit einer Magnetronquelle (10 Q - 100 Ω). Falls der Abgleich für gleiche Ströme erfolgen soll, müssen dementsprechend wieder die Pulslängen angepasst werden. Vor allem bei dieser Betriebsweise ist es wichtig, dass die DC - Versorgungen von der gepulsten Versorgung durch ein Filter, das beispielsweise Dioden enthält, entkoppelt werden. Es hat sich gezeigt, dass dieser Mode vor allem für reaktive Prozesse zur Abscheidung von isolierenden Schichten von Vorteil ist, da nicht nur für die Arcverdampferquelle, sondern vor allem auch für die Sputterquelle sehr breite Prozessfenster verwirklicht werden können. Es kann, beispielsweise, mit konstantem Reaktivgasfluss gearbeitet werden und die Schwierigkeiten der Regelung werden vermieden. Sind die beiden Quellen einander gegenüber angeordnet, reicht das Prozessplasma durch die Substrate hindurch zu der anderen Quelle und verhindert das Vergiften des Sputtertargets über weite Bereiche.

Zusätzliche Vorteile sind:
1. Stark vergrössertes Prozessfenster für den Sputterbetrieb ohne Targetvergiftung;
2. Höhere Reaktivität, vor allem des Sputterprozesses durch höhere Elektronendichten.

In einer weiteren Ausbildung der Erfindung ist die zweite Elektrode als Verdampfungstiegel (22) ausgebildet, welcher Teil einer Niedervoltverdampfungseinrichtung ist, wie dies in Fig. 6 dargestellt ist. Wie bereits erläutert, wird die Niedervoltbogenentladung mit einer DC-Stromversorgung (21) betrieben, welche mit dem positiven Pol an den Verdampfungstiegel (22) angeschlossen ist, welcher hier als Anode dient und mit dem negativen Pol an das Filament einer gegenüberliegenden Plasmaquelle (9), welche hier als Kathode dient. Die Niedervoltbogenentladung kann in bekannter Weise mit den Spulen (10, 10') auf den Tiegel (22) konzentriert werden, wobei dort ein Verdampfungsgut aufschmilzt und verdampft. Die Pulsstromversogung (16) ist wiederum zwischen die Elektrode (5') der Arcverdampferquelle (5) und der zweiten Elektrode, des Verdampfungstiegels (22), geschaltet, zur Erzielung des gewünschten hohen Ionisierungsgrades. Dieses Vorgehen hilft auch bei schwierig zu verdampfenden Materialien, Spritzer zu reduzieren. Selbstverständlich kann auch der Tiegel eines normalen Elektronenstrahlverdampfers als zweite Elektrode für die Pulsstromversorgung benutzt werden.

Die Vorteile sind:
1. Dualer Betrieb erhöht die Ionisierung bei thermischen Verdampfern.
2. Einfache Kombination von thermischer Verdampfung und kathodischer Funkenverdampfung.
3. Effektivere Zerlegung und Anregung des Reaktivgases in der Niedervoltbogenentladung.
4. Nutzung der hohen Elektronenströme der Funkenverdampfung für eine andere thermische Verdampfung.
5. Sehr hohe Flexibilität in der Prozessführung.

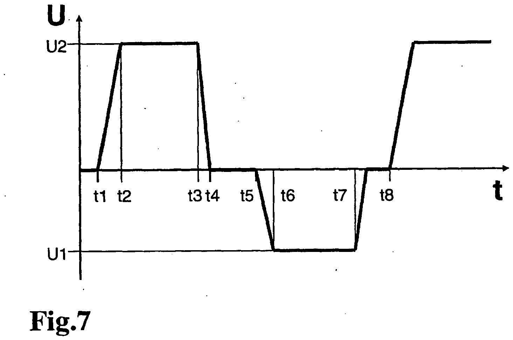

Um die erwähnten vorteilhaften Prozesseigenschaften erzielen zu können bei den vorerwähnten verschiedenen möglichen Ausbildungsformen der Erfindung, muss die Pulsstromversorgung (16) verschiedene Bedingungen erfüllen. Bei bipolarer Pulsdarstellung soll der Prozess bei einer Frequenz betrieben werden können, die im Bereich von 10Hz bis 500kHz liegt. Hierbei wichtig ist, wegen der Ioniserungsverhältnisse, die einhaltbare Flankensteilheit der Pulse. Sowohl die Beträge der ansteigenden Flanken U2/(t2-t1), U1/(t6-t5), wie auch der absteigenden Flanken U2/(t4-t3) und U1/(t8-t7) sollten mindestens Steilheiten aufweisen grösser 2,0Vns über den wesentlichen Teil der Flankenausdehnung gemessen. Sie sollten aber mindestens im Bereich von 0,02V/ns bis 2,0V/ns liegen, vorzugsweise mindestens im Bereich von 0,1V/ns bis 1,0V/ns und dies zumindest im Leerlaufbetrieb also ohne Belastung, vorzugsweise aber auch bei Belastung. Selbstverständlich wirkt sich die Flankensteilheit beim Betrieb aus, je nach entsprechender Höhe der Belastung bzw. der anliegenden Impedanz oder der entsprechend Einstellungen und wie dies im Diagramm nach Fig. 7 dargestellt ist. Die Pulsbreiten bei bipolarer Darstellung sind wie in Fig. 7 gezeigt, für t4 bis t1 und t8 bis t5 mit Vorteil ≥ 1µs, wobei die Pausen t5 bis t4 und t9 bis t8 mit Vorteil im Wesentlichen 0 sein können, aber unter gewissen Voraussetzungen auch ≥ 0µs sein können. Wenn die Pulspausen > 0 sind, wird dieser Betrieb als lückend bezeichnet und es kann durch bspw. variable Zeitverschiebung der Pulslückenbreiten der gezielte Eintrag von Energie in ein Plasma und dessen Stabilisierung eingestellt werden. Beim Betrieb der Pulsstromversorgung zwischen zwei Elektroden unterschiedlicher Impedanz wie oben geschildert, kann es unter Umständen von Vorteil, wenn die Pulsdauern klein gehalten werden, um den Stromanstieg zu begrenzen und die Pulsstromversorgung im lückenden Mode betrieben wird.

Es ist besonders vorteilhaft, wenn die Pulsstromversorgung derart ausgelegt wird, dass ein Pulsbetrieb bis 500A bei 1000V Spannung möglich ist, wobei hierbei das Pulspausenverhältnis (duty cicle) entsprechend berücksichtigt werden muss, bzw. angepasst werden muss für die ausgelegte möglich Leistung der Versorgung. Neben der Flankensteilheit der Pulsspannung ist bevorzugt darauf zu achten, dass die Pulsstromversorgung (16) in der Lage ist einen Stromanstieg auf 500A in mind. 1µs zu bewältigen.

In den folgenden Beispielen wird nun die erste bevorzugte Anwendung der Erfindung beschrieben wie sie in Abbildung 2 schematisch dargestellt ist. In diesem Fall wird die gepulste Hochstromversorgung (16) zwischen zwei kathodischen Funkenverdampfungsquellen (5, 20) betrieben. In dieser Betriebsweise werden sowohl Prozessstabilität für isolierende Schichten, Spritzerreduktion und höhere Reaktivität des Plasmas erreicht.

### Beispiel 1:

Beschreibung eines typischen Prozessablaufes zur Herstellung einer Al-Cr-O-Schicht.

Im folgendem wird ein typischer Ablauf einer Substratbehandlung in einem reaktiven Funkenbeschichtungsprozess geschildert, unter Verwendung der vorliegenden Erfindung. Es wird neben dem eigentlichen Beschichtungsprozess, in dem die Erfindung realisiert wird, auch auf die anderen Prozessschritte eingegangen, die die Vor- und Nachbehandlung der Substrate betreffen. Alle diese Schritte lassen breite Variationen zu, einige können unter bestimmten Bedingungen auch weggelassen, verkürzt oder verlängert oder anders kombiniert werden.

In einem ersten Schritt werden die Substrate gewöhnlich einer nasschemischen Reinigung unterzogen, die je nach Material und Vorgeschichte verschieden durchgeführt wird.
1. Vorbehandlung (Reinigung etc.) der Substrate (Verfahren dem Fachmann bekannt)
2. Einlegen der Substrate in die dafür vorgesehenen Halterungen und Einbringen in das Beschichtungssystem
3. Abpumpen der Beschichtungskammer auf einem Druck von ca. 10-4 mbar mittels eines Pumpsystems wie es dem Fachmann bekannt ist (Vorpumpen/Diffusionspumpe, Vorpumpen/Turbomolekularpumpe, Enddruck ca. 10-7 mbar erreichbar)
4. Starten der Substratvorbehandlung im Vakuum mit einem Heizschritt in einem Argon-Wasserstoffplasma oder einer anderen bekannten Plasmabehandlung. Ohne Einschränkung kann diese Vorbehandlung mit folgenden Parametern durchgeführt werden :
   Plasma einer Niedervoltbogenentladung mit ca. 100 A Entladestrom, bis 200 A, bis 400 A, bevorzugt werden die Substrate als Anode für diese Niedervoltbogenentladung geschaltet.
   Argonfluss 50 sccm
   Wasserstofffluss 300 sccm
   Substrattemperatur 500°C (teils durch Plasmaheizung, teils durch Strahlungsheizung)
   Prozesszeit 45 min
   Bevorzugt wird während dieses Schrittes eine Versorgung zwischen Substrate und Masse oder einem anderen Bezugspotential gelegt, mit der die Substrate sowohl mit DC (bevorzugt positiv) oder DC gepulst (unipolar, bipolar) oder als MF oder RF beaufschlagt werden können.
   5. Als nächster Prozessschritt wird das Aetzen gestartet. Dafür wird der Niedervoltbogen zwischen dem Filament und der Hilfsanode betrieben. Eine DC, gepulste DC, MF oder RF Versorgung wird zwischen Substraten und Masse geschaltet und die Substrate bevorzugt mit negativer Spannung beaufschlagt. Bei den gepulsten und MF, RF Versorgungen wird auch positive Spannung an die Substrate gelegt. Die Versorgungen können unipolar oder bipolar betrieben werden. Die typischen, aber nicht ausschliesslichen Prozessparameter während dieses Schrittes sind:
      Argonfluss 60 sccm
      Entladestrom Niedervoltbogen 150 A
      Substrattemperatur 500°C (teils durch Plasmaheizung, teils durch Strahlungsheizung)
      Prozesszeit 30 min
      Um die Stabilität der Niedervoltbogenentladung bei der Herstellung isolierender Schichten zu gewährleisten, wird entweder mit heisser, leitfähiger Hilfsanode gearbeitet oder eine gepulste Hochstromversorgung zwischen Hilfsanode und Masse geschaltet.
   6. Beginn der Beschichtung mit der Zwischenschicht (ca. 15 min)
      CrN Zwischenschicht 300 nm mittels Funkenverdampfung (Quellenstrom 140 A, N2 1200 sccm, mit bipolar Bias von -180V (36 µs negativ, 4 µs positiv).
      Die Beschichtung kann mit und ohne Niedervoltbogen erfolgen.
      Bis zu diesem Punkt folgt das Verfahren dem Stand der Technik wie er beispielhaft in Figur 1 wiedergegeben ist.
   7. Uebergang zur Funktionsschicht (ca. 5 min)
      Im Uebergang zur eigentlichen Funktionsschicht wird der Stickstoff von 1200 sccm auf ca. 400 sccm heruntergerampt und anschliessend ein Sauerstofffluss von 300 sccm eingeschaltet. Gleichzeitig wird der DC Versorgungsstrom für das das Cr-Funkenkathode auf 200 A erhöht. Danach wird die Al-Funkenkathode eingeschaltet und ebenfalls mit einem Strom von 200 A betrieben. Der Stickstofffluss wird nun ausgeschaltet und anschliessend der Sauerstoffluss auf 400 sccm hochgefahren.
   8. Beschichten mit der Funktionsschicht
      Nun wird die bipolar gepulste Hochstromversorgung (16), wie in Figur 2 dargestellt, zwischen beiden Funkenkathoden in Betrieb genommen. Im beschriebenen Prozess wurde mit einem zeitlichen positiven bzw. negativen Mittelwert des Stromes von ca. 50 A gearbeitet. Die Pulsdauern betragen jeweils 20 µs für den positiven wie negativen Spannungsbereich. Der Spitzenwert des Stroms durch die bipolar gepulste Stromversorgung hängt von der jeweiligen Pulsform ab. Die Differenz aus DC Strom durch die jeweilige Funkenkathode und Spitzenwert des bipolar gepulsten Stromes darf den sog. Haltestrom der Funkenkathode nicht unterschreiten, da sonst der Funken verlöscht.
      Während der ersten 10 Minuten der Beschichtung wird der Bias von -180 V auf -60 V gerampt. Die typischen Beschichtungsraten für doppelt rotierende Substrate liegen zwischen 3 µm/h und 6 µm/h.
      Die Beschichtung der Substrate mit der eigentlichen Funktionsschicht erfolgt also in reinem Reaktivgas (in diesem Beispiel Fall Sauerstoff). Die wichtigsten Prozessparameter sind noch einmal zusammengefasst:
      Sauerstofffluss 300 sccm
      Substrattemperatur 500°C
      DC Quellenstrom 200 A, sowohl für die Al- wie auch für die Cr-Quelle.
      Der bipolar gepulste DC Strom zwischen den beiden Kathoden hat eine Frequenz von 25 kHz.
      Prozessdruck ca. 3x10⁻³ mbär

Wie schon erwähnt, kann die Beschichtung auch simultan mit dem Betrieb des Niedervoltbogen erfolgen. In diesem Falle wird eine weitere Erhöhung der Reaktivität vor allem in Substratnähe erzielt. Ausserdem hat die simultane Benutzung des Niedervoltbogens während der Beschichtung auch noch den Vorteil, dass der DC Anteil bei den Quellen reduziert werden kann. Mit höherem Bogenstrom, kann dieser weiter reduziert werden.

Der so geführte Beschichtungsprozess ist stabil über mehrere Stunden. Das Funkentarget bedeckt sich mit einer dünnen, glatten Oxidschicht. Dies ist erwünscht und auch Voraussetzung für einen weitgehend spritzerfreien und stabilen Prozess. Die Bedeckung manifestiert sich in einer Erhöhung der Spannung am Funkentarget wie es auch bereits in der vorhergehenden Patentanmeldung CH00518/05 beschrieben wurde.

Im Folgenden werden drei weitere Anwendungsbeispiele angeführt, bei denen aber lediglich auf die Abscheidung des Interfaces und der Funktionsschicht eingegangen wird.

### Beispiel 2:

Während im obigen Beispiel die Herstellung einer Al-Cr-O Schicht beschrieben wurde, bei der lediglich zwei Funkentargets benutzt wurden, soll nun im Folgenden der Prozess für eine reine Aluminiumoxidschicht unter Benutzung von 4 Funkentargets beschrieben werden:

Für die Beschichtungen wurden Hartmetallwendeschneidplatten (Wolframcarbid) als Substrate benutzt, die bereits in einem vorhergehenden Verfahren mit einer 1.5 µm dicken TiN-Schicht beschichtet wurden. Die Substrate wurden einer Vorbehandlung unterzogen, die im wesentlichen mit den oben genannte Schritten 1 bis 5 identisch war. Vor der Beschichtung mit der Funktionsschicht wurde aber keine spezielle Zwischenschicht abgeschieden, d.h. es wurde sofort mit der Funktionsschicht auf der TiN-Unterlage begonnen und die Schritte 6 und 7 weggelassen. Zur Abscheidung der Funktionsschicht (8) wurde mit vier Funkentargets gearbeitet und folgende Prozessparameter benutzt:

| | |
|---|---|
| • | 4 Al-Targets betrieben mit je 170 A DC |
| • | bipolares Strompulsen, entsprechend Figur 2, von jeweils 2 Al-Targets mit einer Ausgangsspannung von 100 V an der Stromversorgung und positiven und negativen Pulsbreiten von je 20 µs |
| • | Argonfluss: 50 sccm |
| • | Sauerstofffluss: 700 sccm |
| • | Substratbias: DC bipolar gepulst, +/- 100V, 38 µs negativ, 4 µs positive |
| • | Substrattemperatur: 695°C |

Die auf diese Weise erhaltene Schicht wurde durch folgende Messungen charakterisiert:

| | |
|---|---|
| • | Schichtdicke bei Doppelrotation der Subtrate: 4 µm |
| • | Die Schichthaftung wurde mit Rockwell-Eindrucks-Tests zu HF1 bis HF2 bestimmt. |
| • | Die Mikrohärte wurde mit dem Fischerscope (Microindentation bei F = 50 mN / 20s) ermittelt und betrug HV = 1965 (+/- 200), Y = 319 GPa (+/- 12 GPa). |

Es wurden XRD-Spektren der Schicht durchgeführt sowohl für den Winkelbereich 2Θ/Θ wie für streifenden Einfall (3°). Diese Röntgenmessungen zeigen eine kristalline Schicht mit möglicherweise kleinen Beiträgen an amorphem Aluminiumoxid. Das Aluminiumoxid kann klar als γ-Al₂O₃-Phase identifiziert werden.

### Beispiel 3:

Das nächste Beispiel bezieht sich auf die Herstellung einer Zirkonoxidschicht. Die Substrate wurden vor der eigentlichen Beschichtung mit der Funktionsschicht mit einer Zwischenschicht aus ZrN beschichtet. Für diese Beschichtung wurde mit 4 Targets gearbeitet, die bei einem Sticktoffpartialdruck von 2 Pa mit je 170 A betrieben wurden. Die Substrattemperatur betrug 500°C und es wurde ein Substratbias von - 150 V verwendet. Die Beschichtungszeit für diese Zwischenschicht betrug 6 min.

Zur Abscheidung der Funktionsschicht (8) wurde ebenfalls mit vier Funkentargets, entsprechend Figur 2, gearbeitet und folgende Prozessparameter benutzt:

| | |
|---|---|
| • | 4 Zr-Targets betrieben mit je 170 A DC |
| • | bipolares Strompulsen von jeweils 2 Zr-Targets mit einer Ausgangsspannung von 100 V an der Stromversorgung und positiven und negativen Pulsbreiten von je 20 µs |
| • | Argonfluss: 50 sccm |
| • | Sauerstofffluss: 700 sccm |
| • | Substratbias: DC bipolar gepulst, +/- 40 V, 38 µs negativ, 4 µs positive |
| • | Substrattemperatur: 500°C |

Die auf diese Weise erhaltene Schicht wurde durch folgende Messungen charakterisiert:

| | |
|---|---|
| • | Schichtdicke bei Doppelrotation der Subtrate: 6.5 µm |
| • | Die Schichthaftung wurde mit Rockwell-Eindrucks-Tests zu HF1 bestimmt. |
| • | Die Mikrohärte wurde mit dem Fischerscope (Microindentation bei F = 50 mN / 20s) ermittelt und betrug HV = 2450. |
| • | Die Schichtwerte für die Rauhigkeit betragen Rₐ = 0.41 µm, R_{z} = 3.22 µm, Rₘₐₓ = 4.11 µm |
| • | Der Reibungskoeffizient wurde zu 0.58 ermittelt. |

Durch die Messung der XRD-Spektren der Schicht kann eindeutig Baddeleyite Struktur festgestellt werden.

### Beispiel 4:

Im letzten Beispiel wird auf die Herstellung und Analyse einer SiAlN-Schicht eingegangen.

Die Substrate wurden vor der eigentlichen Beschichtung mit der Funktionsschicht mit einer Zwischenschicht aus TiN beschichtet. Für diese Beschichtung wurde mit 2 Targets gearbeitet, entsprechend Figur 2, die bei einem Sticktoffpartialdruck von 0.8 Pa mit je 180 A betrieben wurden. Die Substrattemperatur betrug 500°C und es wurde ein Substratbias von - 150 V verwendet. Die Beschichtungszeit für diese Zwischenschicht betrug 5 min.

| | |
|---|---|
| • | 2 SiAl-Targets mit einem Si-Al-Verhältnis von 70/30 betrieben mit je 170 A DC |
| • | bipolares Strompulsen der2 SiAl-Targets mit einer Ausgangsspannung von 100 V an der Stromversorgung und positiven und negativen Pulsbreiten von je 20 µs |
| • | Argonfluss: 50 sccm |
| • | Sauerstofffluss: 800 sccm Substratbias: DC bipolar gepulst, +/- 40 V, 38 |
| • | µs negativ, -4 µs positive |
| • | Substrattemperatur: 410°C |

Die auf diese Weise erhaltene Schicht wurde durch folgende Messungen charakterisiert:

| | |
|---|---|
| • | Schichtdicke bei Doppelrotation der Subtrate: 6.5 µm |
| • | Die Schichthaftung wurde mit Rockwell-Eindrucks-Tests zu HF2 bestimmt. |
| • | Die Mikrohärte wurde mit dem Fischerscope (Microindentation bei F = 50 mN / 20s) ermittelt und betrug HV = 1700. |
| • | Die Schichtwerte für die Rauhigkeit betragen Rₐ = 0.48 µm, R_{z} = 4.08 µm, Rₘₐₓ = 5.21 µm |
| • | Der Reibungskoeffizient wurde zu 0.82 ermittelt. |

## Patentansprüche

1. Vakuumprozessanlage mit einer Vakuumkammer (1) zur Oberflächenbearbeitung von Werkstücken (3) mit einer Arcverdampferquelle (5) enthaltend eine Anode (6) und eine erste Elektrode (5') ausgebildet als Targetelektrode, wobei diese Anode (6) und diese Elektrode (5') mit einer DC-Stromversorgung (13) verbunden sind, und mit einer von der Arcverdampferquelle (5) und der Vakuumkammer (1) getrennt angeordneten zweiten Elektrode (3, 18, 20, 22), **dadurch gekennzeichnet, dass** die beiden Elektroden (5', 3, 18, 20, 22) mit einer bipolaren Pulsstromversorgung (16) verbunden sind zur Ausbildung einer zusätzlichen Entladungsstrecke.

2. Anlage nach Anspruch 1, **dadurch gekennzeichnet, dass** die zweite Elektrode (20') die Kathode einer weiteren Arcverdampferquelle (20) ist und diese ebenfalls mit einer DC-Stromversorgung (13') verbunden ist.

3. Anlage nach Anspruch 1, **dadurch gekennzeichnet, dass** die zweite Elektrode (18) die Kathode einer Sputterquelle (18) ist, insbesondere einer Magnetronquelle (18), und diese ebenfalls mit einer Stromversorgung (17) verbunden ist, insbesondere mit einer DC-Stromversorgung.

4. Anlage nach Anspruch 1, **dadurch gekennzeichnet, dass** die zweite Elektrode (3) als Werkstückhalterung (3) ausgebildet ist und zusammen mit den Werkstücken (3) eine Bias-Elektrode bildet.

5. Anlage nach Anspruch 1, **dadurch gekennzeichnet, dass** die zweite Elektrode ein Verdampfungstiegel (22) ist welcher die Anode eines Niedervoltbogenverdampfers (9, 22) bildet.

6. Anlage nach Anspruch 1, **dadurch gekennzeichnet, dass** die zweite Elektrode eine Hilfselektrode (22) ist, vorzugsweise die Hilfsanode (15) für die Ausbildung einer Niedervoltbogenentladung.

7. Anlage nach einem der vorherigen Ansprüche 1 bis 6, **dadurch gekennzeichnet, dass** zwischen der DC-Stromversorgung (13) und der Pulsstromversorgung (16) ein elektrisches Entkopplungsfilter angeordnet ist, wobei dieses vorzugsweise mindestens einer Sperrdiode enthält.

8. Anlage nach einem der Ansprüche 2 oder 3, **dadurch gekennzeichnet, dass** die DC-Stromversorgung (13) einen Grundstrom abgibt zur im wesentlichen unterbrechungsfreien Erhaltung einer Plasmaentladung an den Elektroden (5, 18, 20), insbesondere an den Arcverdampferquellen (5, 20).

9. Anlage nach einem der Ansprüche 1 bis 8, **dadurch gekennzeichnet, dass** die Anlage einen Reaktivgaseinlass aufweist.

10. Anlage nach einem der Ansprüche 1 bis 9, **dadurch gekennzeichnet, dass** die Frequenz der Pulsstromversorgung (16) im Bereich von 1kHz bis 200kHz liegt.

11. Anlage nach einem der Ansprüche 1 bis 10, **dadurch gekennzeichnet, dass** das Pulsbreitenverhältnis der Pulsstromversorgung (16) unterschiedlich eingestellt ist.

12. Anlage nach einem der Ansprüche 1 bis 11, **dadurch gekennzeichnet, dass** die Pulse der Pulsstromversorgung (16) lückend eingestellt ist.

13. Anlage nach einem der Ansprüche 1 bis 12, **dadurch gekennzeichnet, dass** die Pulsflanken der Pulsstromversorgung (16) Steilheiten aufweisen mindestens im Bereich von 0,02 V/ns bis 2,0 V/ns liegend, vorzugsweise mindestens im Bereich von 0,1 V/ns bis 1,0V/ns liegend, vorzugsweise grösser 2,0 V/ns.

14. Verfahren zur Oberflächenbearbeitung von Werkstücken (3) in einer Vakuumprozessanlage (1) mit einer Vakuumkammer (1), in dem mit einer ersten Elektrode (5'), ausgebildet als Targetelektrode einer Arcverdampferquelle (5) enthaltend eine Anode (6), und mit einer von der Arcverdampferquelle (5) und der Vakuumkammer (1) getrennt angeordneten zweiten Elektrode (3, 18, 20, 22) eine Schicht auf das Werkstück (3) abgeschieden wird, wobei die erste Elektrode (5') der Arcverdampferquelle (5) und die Anode (6) mit einer DC - Stromversorgung verbunden gespiesen werden, **dadurch gekennzeichnet, dass** beide Elektroden (5', 3, 18, 20, 22) mit einer einzelnen bipolaren Pulsstromversorgung (16) verbunden betrieben werden und dadurch zwischen den Elektroden eine zusätzliche Entladungsstrecke betrieben wird.

15. Verfahren nach Anspruch 14, **dadurch gekennzeichnet, dass** die zweite Elektrode (20') als Kathode einer weiteren Arcverdampferquelle (20) betrieben wird und diese ebenfalls mit einer DC-Stromversorgung (13') verbunden, betrieben wird.

16. Verfahren nach Anspruch 14, **dadurch gekennzeichnet, dass** die zweite Elektrode (18) als Kathode einer Sputterquelle (18) betrieben wird, insbesondere einer Magnetronquelle (18), und diese ebenfalls mit einer Stromversorgung (17) verbunden, betrieben wird, insbesondere mit einer DC-Stromversorgung.

17. Verfahrten nach Anspruch 14, **dadurch gekennzeichnet, dass** die zweite Elektrode (3) als Werkstückhalterung (3) ausgebildet wird und zusammen mit den Werkstücken (3) eine Bias-Elektrode bildet.

18. Verfahren nach Anspruch 14, **dadurch gekennzeichnet, dass** die zweite Elektrode als Verdampfungstiegel (22) ausgebildet ist und als die Anode eines Niedervoltbogenverdampfers (9, 22) betrieben wird.

19. Verfahren nach Anspruch 14, **dadurch gekennzeichnet, dass** die zweite Elektrode als Hilfselektrode (22) betrieben wird, vorzugsweise als Hilfsanode (15) für die Ausbildung einer Niedervoltbogenentladung.

20. Verfahren nach einem der vorherigen Ansprüche 14 bis 19, **dadurch gekennzeichnet, dass** die DC-Stromversorgung (13) und die Pulsstromversorgung (16) mit einem elektrischen Entkopplungsfilter entkoppelt wird, wobei dieses vorzugsweise mindestens eine Sperrdiode enthält.

21. Verfahren nach einem der Ansprüche 15 oder 16, **dadurch gekennzeichnet, dass** die DC-Stromversorgung (13) mit einem Grundstrom betrieben wird, derart dass die Plasmaentladung an den Elektroden (5, 18, 20) im wesentlichen unterbrechungsfrei aufrecht erhalten wird, insbesondere an den Arcverdampferquellen (5, 20).

22. Verfahren nach einem der Ansprüche 14 bis 21, **dadurch gekennzeichnet, dass** die Vakummprozessanlage mit einem Prozessgas betrieben wird, welches ein Reaktivgas enthält.

23. Verfahren nach Anspruch 22, **dadurch gekennzeichnet, dass** die Vakummprozessanlage mit einem Prozessgas betrieben wird, welches ausschliesslich ein Reaktivgas ist.

24. Verfahren nach einem der Ansprüche 22 oder 23, **dadurch gekennzeichnet, dass** die Vakummprozessanlage mit einem Prozessgas betrieben wird, bei welchem das Reaktivgas Sauerstoff enthält und vorzugsweise im wesentlichen Sauerstoff ist.

25. Verfahren nach einem der Ansprüche 14 bis 24, **dadurch gekennzeichnet, dass** die Pulsstromversorgung (16) mit einer Frequenz im Bereich von 1kHz bis 200kHz betrieben wird.

26. Verfahren nach einem der Ansprüche 14 bis 25, **dadurch gekennzeichnet, dass** die Pulsstromversorgung (16) mit einem unterschiedlichen Pulsbreitenverhältnis eingestellt betrieben wird.

27. Verfahren nach einem der Ansprüche 14 bis 26, **dadurch gekennzeichnet, dass** die Pulsstromversorgung (16) mit lückenden Pulsen betrieben wird.

28. Verfahren nach einem der Ansprüche 14 bis 27, **dadurch gekennzeichnet, dass** die Pulsstromversorgung (16) mit Pulsflanken betrieben wird, die Steilheiten aufweisen, mindestens im Bereich von 0,02 V/ns bis 2,0 V/ns liegend, vorzugsweise mindestens im Bereich von 0,1 V/ns bis 1,0 V/ns liegend, vorzugsweise grösser 2,0 V/ns.

29. Verfahren nach einem der Ansprüche 14 bis 28, **dadurch gekennzeichnet, dass** mehr als zwei Elektroden (5, 5', 3, 18, 20) in der Vakuumprozessanlage (19) enthaltend Reaktivgas, vorzugsweise ausschliesslich Reaktivgas enthaltend, betrieben werden, wobei nur zwei Elektroden mit einer einzelnen Pulsstromversorgung (16) betrieben werden und die eine der beiden Elektroden als erste Elektrode (5') einer Arcverdampferquelle (5) betrieben wird.

30. Verfahren nach Anspruch 29, **dadurch gekennzeichnet, dass** die zwei gepulsten Elektroden (5, 5') als Arcverdampferquellen (5,20) betrieben werden und mindestens eine weitere Elektrode als Sputterquelle (18) betrieben wird.

## Claims

1. Vacuum process system with a vacuum chamber (1) for surface treatment of workpieces (3) with an arc evaporation sources (5) containing an anode (6) and a first electrode (5') formed as a target electrode, wherein this anode (6) and this electrode (5') are connected with a DC power supply (13), and with a second electrode (3, 18, 20, 22) arranged separated from the arc evaporation source (5) and vacuum chamber (1), **characterised in that** the two electrodes (5', 3, 18, 20, 22) are connected with a bipolar pulsed current supply (16) to form an additional discharge path.

2. System according to claim 1, **characterised in that** the second electrode (20') is the cathode of a further arc evaporation source (20) and this is also connected with a DC power supply (13').

3. System according to claim 1, **characterised in that** the second electrode (18) is the cathode of a sputter source (18), in particular a magnetron source (18), and this is also connected with a power supply (17), in particular a DC power supply.

4. System according to claim 1, **characterised in that** the second electrode (3) is formed as a workpiece holder (3) and together with the workpieces (3) forms a bias electrode.

5. System according to claim 1, **characterised in that** the second electrode is an evaporation crucible (22) which forms the anode of a low voltage arc evaporator (9, 22).

6. System according to claim 1, **characterised in that** the second electrode is an auxiliary electrode (22), preferably the auxiliary electrode (15) for forming a low voltage arc discharge.

7. System according to any of the preceding claims 1 to 6, **characterised in that** between the DC power supply (13) and the pulsed current supply (16) is arranged an electric decoupling filter, wherein this preferably contains at least one blocking diode.

8. System according to one of claims 2 or 3, **characterised in that** the DC power supply (13) emits a base current to maintain a substantially uninterrupted plasma discharge at the electrodes (5, 18, 20), in particular at the arc evaporation sources (5, 20).

9. System according to any of claims 1 to 8, **characterised in that** the system comprises a reactive gas inlet.

10. System according to any of claims 1 to 9, **characterised in that** the frequency of the pulsed current supply (16) lies the range from 1 kHz to 200 kHz.

11. System according to any of claims 1 to 10, **characterised in that** the pulse width ratio of the pulsed current supply (16) is set variably.

12. System according to any of claims 1 to 11, **characterised in that** the pulse of the pulsed current supply (16) is set intermittently.

13. System according to any of claims 1 to 12, **characterised in that** the pulse flanks of the pulsed current supply (16) have gradients lying at least in the range from 0.02 V/ns to 2.0 V/ns, preferably lying at least in the range from 0.1 V/ns to 1.0 V/ns, preferably greater than 2.0 V/ns.

14. Method for surface treatment of workpieces (3) in a vacuum process system (1) with a vacuum chamber (1), in which with a first electrode (5') formed as a target electrode of an arc evaporation source (5) containing an anode (6), and with a second electrode (3, 18, 20, 22) arranged separated from the arc evaporation source (5) and the vacuum chamber (1), a coating is deposited on the workpiece (3), wherein the first electrode (5') of the arc evaporation source (5) and the anode (6) are supplied connected with a DC power supply, **characterised in that** the two electrodes (5', 3, 18, 20, 22) are operated connected with a single bipolar pulsed current supply (16) and thus between the electrodes an additional discharge path is operated.

15. Method according to claim 14, **characterised in that** the second electrode (20') is operated as a cathode of a further arc evaporation source (20) and this is also operated connected with a DC power supply (13').

16. Method according to claim 14, **characterised in that** the second electrode (18) is operated as the cathode of a sputter source (18), in particular a magnetron source (18), and this is also operated connected with a power supply (17), in particular a DC power supply.

17. Method according to claim 14, **characterised in that** the second electrode (3) is formed as a workpiece holder (3) and together with the workpieces (3) forms a bias electrode.

18. Method according to claim 14, **characterised in that** the second electrode is formed as an evaporation crucible (22) and is operated as the anode of a low voltage arc evaporator (9, 22).

19. Method according to claim 14, **characterised in that** the second electrode is operated as an auxiliary electrode (22), preferably as an auxiliary electrode (15) for forming a low voltage arc discharge.

20. Method according to any of the preceding claims 14 to 19, **characterised in that** the DC power supply (13) and the pulsed current supply (16) are decoupled by an electric decoupling filter, wherein this preferably contains at least one blocking diode.

21. Method according to one of claims 15 or 16, **characterised in that** the DC power supply (13) is operated with a base current such that the plasma discharge at the electrodes (5, 18, 20) is maintained substantially uninterrupted, in particular at the arc evaporation sources (5, 20).

22. Method according to any of claims 14 to 21, **characterised in that** the vacuum process system is operated with a process gas which contains a reactive gas.

23. Method according to claim 22, **characterised in that** the vacuum process system is operated with a process gas which is exclusively a reactive gas.

24. Method according to one of claims 22 or 23, **characterised in that** the vacuum process system is operated with a process gas in which the reactive gas contains oxygen and is preferably substantially oxygen.

25. Method according to any of claims 14 to 24, **characterised in that** the pulsed current supply (16) is operated at a frequency in the range from 1 kHz to 200 kHz.

26. Method according to any of claims 14 to 25, **characterised in that** the pulsed current supply (16) is operated with a variably set pulse width ratio.

27. Method according to any of claims 14 to 26, **characterised in that** the pulsed current supply (16) is operated with intermittent pulses.

28. Method according to any of claims 14 to 27, **characterised in that** the pulsed current supply (16) is operated with pulse flanks which have gradients lying at least in the range from 0.02 V/ns to 2.0 V/ns, preferably lying at least in the range from 0.1 V/ns to 1.0 V/ns, preferably greater than 2.0 V/ns.

29. Method according to any of claims 14 to 28, **characterised in that** more than two electrodes (5, 5', 3, 18, 20) are operated in the vacuum process plant (19) containing reactive gas, preferably exclusively reactive gas, wherein only two electrodes are operated with a single pulsed current supply (16) and the one of the two electrodes is operated as the first electrode (5') of an arc evaporation source (5).

30. Method according to claim 29, **characterised in that** the two pulsed electrodes (5, 5') are operated as arc evaporation sources (5, 20) and at least one further electrode is operated as a sputter source (18).

## Revendications

1. Installation de traitement sous vide incluant une chambre de vide (1) pour le façonnage superficiel de pièces à usiner (3) incluant une source d'évaporation (5) par arc contenant une anode (6) et une deuxième électrode (5') en forme d'électrode cible où cette anode (6) et cette électrode cible (5') sont connectées à une alimentation (13) en courant continu (DC, abrégé de direct current), et incluent aussi une deuxième électrode (3, 18, 20, 22) disposée de manière séparée de la source d'évaporation (5) par arc et de la chambre de vide (1), **caractérisée en ce que** les deux électrodes (5', 3, 18, 20, 22) sont connectées à une alimentation (16) en courant bipolaire pulsée pour former un itinéraire additionnel de décharge.

2. Installation selon la revendication 1, **caractérisée en ce que** la deuxième électrode (20') est la cathode d'une autre source d'évaporation (20) par arc et que celle-ci est également connectée à une alimentation (13') en courant continu.

3. Installation selon la revendication 1, **caractérisée en ce que** la deuxième électrode (18) est la cathode d'une source de pulvérisation cathodique (18), en particulier une source magnétron (18) et que celle-ci est également connectée à une alimentation (17) en courant, en particulier une alimentation en courant continu.

4. Installation selon la revendication 1, **caractérisée en ce que** la deuxième électrode (3) est en forme de support (3) de pièces à usiner et forme, avec les pièces à usiner (3), une électrode de polarisation.

5. Installation selon la revendication 1, **caractérisée en ce que** la deuxième électrode est un creuset d'évaporation (22) qui forme l'anode d'un évaporateur (9, 22) par arc à basse tension.

6. Installation selon la revendication 1, **caractérisée en ce que** la deuxième électrode est une électrode auxiliaire (22), de préférence l'électrode auxiliaire (15) de formation de la décharge par arc à basse tension.

7. Installation selon l'une quelconque des revendications précédentes, **caractérisée en ce qu'**un filtre de découplage électrique qui contient de préférence au moins une diode barrière est disposé entre l'alimentation (13) en courant continu et l'alimentation (16) en courant pulsé.

8. Installation selon la revendication 2 ou 3, **caractérisée en ce que** l'alimentation (13) en courant continu fournit un courant de base pour le maintien essentiellement exempt d'interruption d'une décharge plasma aux électrodes (5, 18, 20), en particulier aux sources d'évaporation (5, 20) par arc.

9. Installation selon l'une quelconque des revendications précédentes, **caractérisée en ce que** l'installation comporte une admission de gaz réactifs.

10. Installation selon l'une quelconque des revendications précédentes, **caractérisée en ce que** la fréquence de l'alimentation (16) en courant pulsé est dans la plage de 1 kHz à 200 kHz.

11. Installation selon l'une quelconque des revendications précédentes, **caractérisée en ce que** le réglage du rapport des largeurs d'impulsions de l'alimentation (16) en courant pulsé présente des variations.

12. Installation selon l'une quelconque des revendications précédentes, **caractérisée en ce que** le réglage des impulsions de l'alimentation (16) en courant pulsé comporte des lacunes.

13. Installation selon l'une quelconque des revendications précédentes, **caractérisée en ce que** les flancs d'impulsions de l'alimentation (16) en courant pulsé présentent des pentes au moins dans la plage de 0,02 V/ns à 2,0 V/ns, de préférence au moins dans la plage de 0,1 V/ns à 1,0 V/ns, de préférence supérieures à 2,0 V/ns.

14. Procédé de façonnage superficiel de pièces à usiner (3) dans une installation (1) de traitement sous vide incluant une chambre de vide (1), dans laquelle une couche est déposée sur la pièce à usiner (3) au moyen d'une première électrode (5') en forme d'électrode cible d'une source d'évaporation (5) par arc contenant une anode (6), et au moyen aussi d'une deuxième électrode (3, 18, 20, 22) disposée de manière séparée de la source d'évaporation (5) par arc et de la chambre de vide (1), où la première électrode (5') de la source (5) d'évaporation par arc et l'anode (6) sont alimentées en étant connectées à une alimentation en courant continu, **caractérisé en ce que** les deux électrodes (5', 3, 18, 20, 22) fonctionnent en étant connectées à une alimentation bipolaire unique (16) en courant pulsé et qu'un itinéraire additionnel de décharge fonctionne de ce fait entre les électrodes.

15. Procédé selon la revendication 14, **caractérisé en ce que** la deuxième électrode (20') fonctionne comme cathode d'une autre source d'évaporation (20) par arc et que celle-ci est également connectée à une alimentation (13') en courant continu.

16. Procédé selon la revendication 14, **caractérisé en ce que** la deuxième électrode (18) fonctionne comme cathode d'une source (18) de pulvérisation cathodique, en particulier une source magnétron (18) et que celle-ci est également connectée à une alimentation (17) en courant, en particulier une alimentation en courant continu.

17. Procédé selon la revendication 14, caractérisé en ce la deuxième électrode (3) est en forme de support (3) de pièce à usiner et forme, avec les pièces à usiner (3) une électrode de polarisation.

18. Procédé selon la revendication 14, caractérisé en que la deuxième électrode est en forme de creuset d'évaporation (22) et fonctionne comme anode d'un évaporateur (9, 22) par arc à basse tension.

19. Procédé selon la revendication 14, **caractérisé en ce que** la deuxième électrode fonctionne comme électrode auxiliaire (22), de préférence comme électrode auxiliaire (15) de formation d'une décharge par arc à basse tension.

20. Procédé selon l'une quelconque des revendications 14 à 19, **caractérisé en ce que** l'alimentation (13) en courant continu et l'alimentation (16) en courant pulsé sont découplées au moyen d'un filtre de découplage électrique, qui contient de préférence au moins une diode barrière.

21. Procédé selon la revendication 15 ou 16, **caractérisé en ce que** l'alimentation (13) en courant continu fonctionne avec un courant de base d'une manière telle que la décharge plasma aux électrodes (5, 18, 20) est maintenue sensiblement exempte d'interruption, en particulier aux sources (5, 20) d'évaporation par arc.

22. Procédé selon l'une quelconque des revendications 14 à 21, **caractérisé en ce que** l'installation de traitement sous vide fonctionne avec un gaz de traitement qui est un gaz réactif.

23. Procédé selon la revendication 22, **caractérisé en ce que** l'installation de traitement sous vide fonctionne avec un gaz de traitement qui est exclusivement un gaz réactif.

24. Procédé selon la revendication 22 ou 23, **caractérisé en ce que** l'installation de traitement sous vide fonctionne avec un gaz de traitement dans lequel le gaz réactif contient de l'oxygène et de préférence sensiblement de l'oxygène.

25. Procédé selon l'une quelconque des revendications 14 à 24, **caractérisé en ce que** l'alimentation (16) en courant pulsé fonctionne à une fréquence dans la plage de 1 kHz à 200 kHz.

26. Procédé selon l'une quelconque des revendications 14 à 25, **caractérisé en ce que** le réglage du rapport de largeurs d'impulsions de fonctionnement de l'alimentation (16) en courant pulsé présente des variations.

27. Procédé selon l'une quelconque des revendications 14 à 26, **caractérisé en ce que** l'alimentation (16) en courant pulsé fonctionne avec des d'impulsions présentant des lacunes.

28. Procédé selon l'une quelconque des revendications 14 à 27, **caractérisé en ce que** l'alimentation (16) en courant pulsé fonctionne avec des flancs d'impulsions qui présentent des pentes au moins dans la plage de 0,02 V/ns à 2,0 V/ns, de préférence au moins dans la plage de 0,1 V/ns à 1,0 V/ns, de préférence supérieures à 2,0 V/ns.

29. Procédé selon l'une quelconque des revendications 14 à 28, **caractérisé en ce que** plus de deux électrodes (5, 5', 3, 18, 20) fonctionnent dans l'installation (19) de traitement sous vide contenant un gaz réactif, de préférence exclusivement un gaz réactif, où seules deux électrodes fonctionnent au moyen d'une alimentation unique (16) en courant pulsé et l'une des deux électrodes fonctionne comme première électrode (5') d'une source d'évaporation (5) par arc pulsée.

30. Procédé selon la revendication 29, **caractérisé en ce que** les deux électrodes pulsées (5, 5') fonctionnent comme sources (5, 20) d'évaporateurs par arc et au moins une autre électrodes fonctionne comme source (18) de pulvérisation cathodique.
